(19) **Europäisches Patentamt**

**European Patent Office**

**Office européen des brevets**

(11) **EP 0 984 556 A2**

(12) **EUROPEAN PATENT APPLICATION**

(43) Date of publication:
08.03.2000 Bulletin 2000/10

(51) Int Cl.$^7$: **H03H 17/02**

(21) Application number: **99306682.8**

(22) Date of filing: **23.08.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **03.09.1998 US 146591**

(71) Applicant: **LUCENT TECHNOLOGIES INC.**
**Murray Hill, New Jersey 07974-0636 (US)**

(72) Inventor: **Johnson, Robert Everest**
**Randolph, New Jersey 07869 (US)**

(74) Representative:
**Buckley, Christopher Simon Thirsk et al**
**Lucent Technologies (UK) Ltd,**
**5 Mornington Road**
**Woodford Green, Essex IG8 0TU (GB)**

(54) **Digital glitch filter**

(57)    A glitch filter processes overlapping time sequences of an odd number, N, of potentially corrupted sampled data values to determine the central value for a sorted ordering of each set of N values present for each time interval, $t_i$. This central value is taken as the output value for the current set of N input values (*i.e.* for time interval, $t_i$). In the following time interval, $t_{i+1}$, the oldest of the previous N samples is discarded and a new sample is added to the set. This process repeats for each time interval. In an illustrative hardware embodiment, a circuit, such as a FPLA, uses the above-described technique to eliminate glitches occurring in signals otherwise being processed. In an illustrative software embodiment, a processor executes a software routine or computer program to similarly evaluate and eliminate glitches imposed on desired signals.

**Description**

**Field of the Invention**

The present invention relates generally to the field of filters. More particularly, the present invention relates, in one aspect, to filters for processing data samples. Still more particularly, aspects of the present invention relate to circuits and methods for removing glitches, spikes, dropouts or other short-term anomalies in digital data samples.

**Background of the Invention**

Many electronic circuits, data buses, interfaces and transmission media suffer from noise and distortions imposed by extraneous internal and external factors, such as adjacent signal sources, switching-induced transients and the like. The results of such extraneous impositions often take the form of sharp rises or declines of a signal amplitude at some point in a circuit or medium, where the rise or fall is unrelated to a desired signal. Because the frequency, polarity, duration and geometry of such interferences or noises vary, they are known by a number of names. For example, when these interfering signals are of short duration and (usually) aperiodic, they are often called "glitches" or "dropouts," and will be referred to hereinafter simply as "glitches."

Many attempted solutions have been devised for treating signal glitches, with each proving suitable in varying degrees for some range of signal or operating conditions. Some solutions prove relatively more advantageous when built as an internal or external complementary circuit, with or without partial firmware or software support. In other cases solutions have been applied in the form of executable software (programs) for use with a general purpose or special purpose processor. No generally applicable technique has proven useful in both hardware and software implementations.

**Summary of the Invention**

Limitations of the prior art are overcome and a technical advance is made in accordance with the present invention described in illustrative glitch filter embodiments applicable to signals that are sampled in consecutive time intervals $t_i$, $i$= 1, 2, ....

In one aspect, the present invention, in illustrative embodiments, provides for processing overlapping time sequences of an odd number, N, of sampled data values to determine the central value for a sorted ordering of each set of N values present for each time interval, $t_i$. This central value is taken as the output value for the current set of N input values *(i.e.* for time interval, $t_i$). In the following time interval, $t_{i+1}$, the oldest of the previous N samples is discarded and a new sample is added to the set. This process repeats for each time interval.

In an illustrative hardware embodiment, a circuit, such as a semiconductor chip circuit, *(e.g.,* a field programmed logic array, FPLA) uses the above-described technique to eliminate glitches occurring in signals otherwise being processed. In accordance with an illustrative software embodiment of the present invention, a processor executes a software routine or computer program to similarly evaluate and eliminate glitches imposed on desired signals.

**Brief Description of the Drawing**

The above-summarized description of illustrative embodiments of the present invention will be more fully understood upon a consideration of the following detailed description and the attached drawing, wherein:

FIG. 1 shows a typical desired signal corrupted by a glitch.

FIG. 2 shows the desired signal of FIG. 1 with the glitch removed in accordance with the principles of the present invention.

FIG. 3 shows an overview of an illustrative embodiment of a system that can be implemented using primarily hardware elements or using a combination of hardware and software elements.

FIG. 4 shows an illustrative hardware implementation of an embodiment of the present invention.

FIG. 5 is a flowchart relating to aspects of an illustrative software embodiment of the present invention.

**Detailed Description**

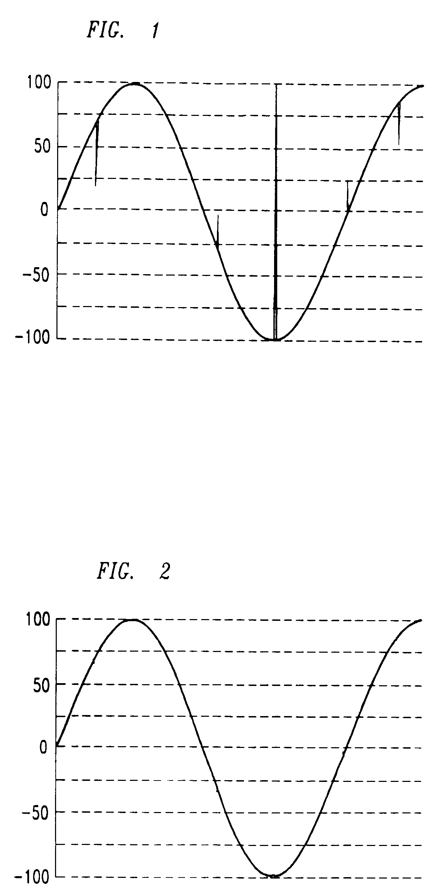

FIG. 1 shows a typical glitch-corrupted signal, such as an audio signal otherwise suitable for reproduction or other normal processing. In the context of audio signals, a listener might recognize such glitches as objectionable crackles or snapping sounds. FIG. 2 shows the signal of FIG. 1 with the glitches removed through the use of the principles and techniques of the present invention as employed using one of many possible embodiments.

Specifically, FIG. 1 shows a number of short-term spikes or glitches of varying magnitude, polarity and spacing superimposed on sine wave. Other standard techniques, such as an illustrative 7-tap finite-impulse-response (FIR) digital filter applied to removing these glitches typically meets with mixed success. That is, though the amplitude of particular glitches may be reduced, they generally are not removed - and their geometry *(e.g.,* their width) may actually be increased. FIG. 2, by contrast shows the sine wave of FIG. 1 with all of the glitches effectively removed using the present inventive teachings.

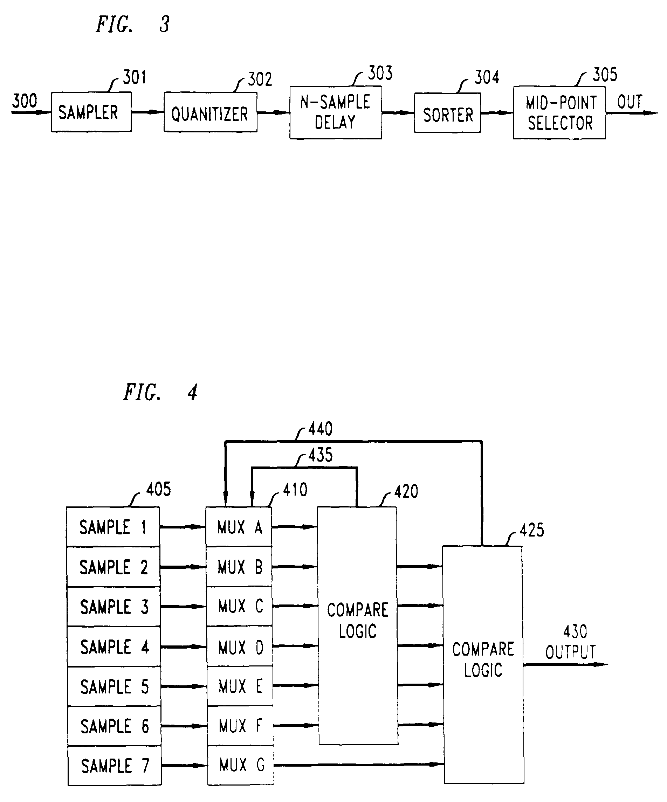

FIG. 3 shows a block diagram of a generic system for performing aspects of the present invention in a variety of detailed embodiments. Shown there is a sampler 301 arranged to receive input signals, illustratively analog signals such as shown in FIG. 1, on input lead 300. In appropriate cases input signals on lead 300 may already have been sampled, in which case sampler 301 may merely pass on the input signals, or may sample at a different rate - as will be determined by those skilled in the art to accommodate particular circumstances. Whether the input signals on lead 300 are samples or nominally continuous signals they will reflect the presence of any extraneous glitches as anomalous variations in pulse amplitude. In general, the sampling rate of sampler 301 is chosen as sufficiently high to capture substantially all glitch-affected amplitude values in one or more samples. The output of sampler circuit 301 is a sequence of samples reflecting any existing glitches. For purposes of reference, the sampling rate will be taken as $1/t$, where $t$ is the sampling period; one sample is therefore generated at each multiple of $t$, *i.e.,* at $t_i$, $i$ = 1, 2, ....

Quantizer 302 receives the sampled output from sampler 301 and generates a multi-bit representation of the value of each sample. In one illustrative case, the samples are transformed into 8-bit digital values, though other particular sample granularities may be used in particular cases. One such sample is generated for each $t_i$.

N-sample delay circuit 303 receives each digital representation of the sample value and retains the most recent N samples. In one illustrative case, N = 7 and delay circuit 303 retains the seven most recent samples. After each $t$-second interval, the oldest sample value is discarded and the next new sample is received and temporarily retained by delay circuit 303. Delay circuit 303 may in typical embodiments be implemented as a multi-bit shift register, a standard multi-bit memory with addressable pointers, a circular buffer, or any of a variety of other particular circuit realizations.

Advantageously, all N values stored in delay circuit 303 are made available during a current $t$-second time interval to sorter 304. A principal function performed by sorter 304 is to order the current N values presented to it in increasing (or decreasing) value order. Since N is advantageously chosen to be an odd number *(e.g.,* 7), the central sample value in the ordered list of N values for the current time interval is readily identified and selected by mid-point selector 305. The output of mid-point selector 305 is the glitch filter output. It proves convenient to have the ordered time samples as sorted by sorter 304 stored in a set of registers or memory locations in a physical or logical position known to selector 305, so that the actual selection is merely a read-out of a predictable location.

FIG. 4 is a particular illustrative hardware embodiment of the sorter and related elements of the system of FIG. 3. Specifically, shown in FIG. 4 is a representation of the N-sample delay element 303 of FIG. 3, appearing as sample store 405. As will be seen, for the illustrative value N = 7, sample store 405 is shown storing samples 1 through 7 in respective storage registers. As noted above, the contents of sample store are changed at each change of $t_i$, with sample $j$ becoming sample $(j + 1)$, for $j$ = 1, 2, ..., 6 at each change of time interval. Sample 7 is discarded as the new sample 1 is added at the top of sample store 405. As noted above, the actual hardware implementation of sample store 405 may assume the form of a shift register, random access memory with resettable pointers, or any other suitable store for implementing the (logically shifting) N sample values. For convenience of reference, each of the sample values 1-7 will be said to be stored in a respective register. The last seven of the sequence of time samples are always retained in sample store 405.

Seven registered octal four-input (4-to-1) multiplexors (muxes A through G) are shown as 410 in FIG. 4. For convenience of reference, mux A, for example, is said to be "above" mux B, and mux G is said to be "below" mux F, etc. These muxes receive as inputs the sample values stored in respective ones of the registers in sample store 405. In addition possible inputs to each mux include: the mux output located adjacently above (none for mux A), the mux output located adjacently below (none for mux G), and the mux's current value fed back from it's output. Control inputs 435 and 440 are received at the muxes from compare logic modules 420 and 425, along with standard clocking and timing controls known to those skilled in the art.

Illustratively, during the first clock after new data is input, mux select lines advantageously select the sample values for latching into the mux registers. During the next seven clock cycles, the compare logic modules evaluate the magnitudes of alternate pairs of registered values. In one illustrative sequence, the compare logic modules 420 and 425 first compares the values stored at muxes A&B, C&D, and E&F. On the next clock cycle, muxes B&C, D&E, and F&G are compared. After each compare, if the more positive value is above the more negative value, the select lines from the compare logic modules 420 and 425 command the muxes to hold their current values. If, however, the more positive value is below the more negative value, the compare logic commands the two muxes to swap their values. After seven compare cycles, the mux registers will hold the sorted values with the most positive value in mux A and the most negative value in mux G. The mux D value is the central value provided as the output, *i.e.,* selection by the mid-point or central selector 305 in FIG. 3 is implicit in the designation of the mux D register as the output. The details of the compare logic and related clocking and timing will vary with particular logic building blocks and/or implementation tools, and are well known to those skilled in the art. It will be appreciated that the "above" and "below" position designators can be uniformly reversed, if it should prove convenient, when the selection is made of the central sample in the N-sample sorted list (with N an odd-integer).

In one illustrative hardware embodiment, the elements and operating sequences of the circuit of FIG. 4 are conveniently realized using a standard ATMEL field programmable gate array (FPGA) as configured using standard development tools associated with such FPGAs.

**Illustrative Software Embodiments**

Software versions of the sorting filter permit input data to be read from a disk file or real-time delay elements implementing the functionality of N-sample delay 301 of FIG. 3. Computed filtered values are then written to disk or other memory for subsequent use or inspection. Software versions of the present invention typically permit easy modification of N, the number of samples retained for processing. This allows a user to observe the effect of changing this parameter for particular datasets.

A variety of algorithms may be used for sorting the current set of N sample values, as is well known in the art. Moreover, particular algorithms well suited to hardware implementations of the present invention may be less desirable for some software embodiments. However, though the sorting and related algorithms may differ in their detail, results of using such algorithms in the various embodiments are substantially identical.

In software embodiments, the N-sample delay element (or circular buffer) is advantageously similar to the above-described hardware implementations. In one software embodiment, an index into a circular buffer array (cbuf) increments each iteration and wraps around (is cleared to 0) when it reaches N. In this context, and before a new value over-writes an old value in the circular buffer, the old value is advantageously temporarily retained and searched for in a sorted buffer array (equivalent to the registered muxes). Only the location holding this old value is updated in the sorted buffer. Since only the new value is out of order in the sorted buffer after each update, only one sorting pass is needed to achieve a complete sort. If the entire circular buffer contents were copied to the sorted buffer each time before the sort, the sorting process would require seven sorting passes and thus take much longer.

It should be noted that while the advantageous single-pass sort is difficult to implement in some hardware versions, these hardware embodiments offer efficiencies not easily realized in software embodiments. Thus, for example, FPGA and other hardware implementations benefit by being able to perform multiple compares and swaps in parallel - operations which often prove difficult or impossible in software embodiments.

An illustrative sorting algorithm is written as a callable routine of the form:

median_value = sort_filter(j);

where j is the current sample. The software advantageously comprises a routine sort_filter( ), and two other routines - sort_top_down( ), and sort_bottom_up( ). The program shown in Appendix A opens disk files A:\data_file.txt and A:\sim_out.txt, reads the next value of j from data_file.txt, passes that value to sort_filter( ), then writes returned value to the output file A:\sim_out.txt.

The Sort_filter( ) routine is presented in Appendix B. There, it will be seen that initially several #defines are declared which make for more understandable code i.e. SAMPLE_SIZE defined as 7. Next two arrays cbuf[ ] and sbuf [ ] are declared which are the circular buffer and the sorted buffer. They are sized to hold SAMPLE_SIZE number of values. The arrays and the indexes into these arrays - cndx and sndx - are declared as static variables so their values are retained from one invocation of sort_filter to the next. The routine first increments the circular buffer index variable cndx to point to the next array location. The index wraps around to 0 when it reaches SAMPLE_SIZE. Next the old value at that location is saved in old_value then the new sample overwrites the old.

The software then searches through the sorted buffer to find the first occurrence of old_value. When the value is found it is replaced with the new sample value and the search loop exits with the break statement.

Finally, the routine calls sort_top_down( ), and sort_bottom_up( ). Sort_top_down first compares the first array value with the second and swaps them if required to get the larger value into the first location. Then the routine compares the second and the third and so on progressing down the array. Sort_top_down moves the new sample down the array to correctly position it. Likewise, sort_bottom_up moves the new sample up the array if need be, to correctly position it. After both of these have been called, the new sample is correctly placed and the central value is returned with the return sbuf[MEDIAN_VALUE] statement.

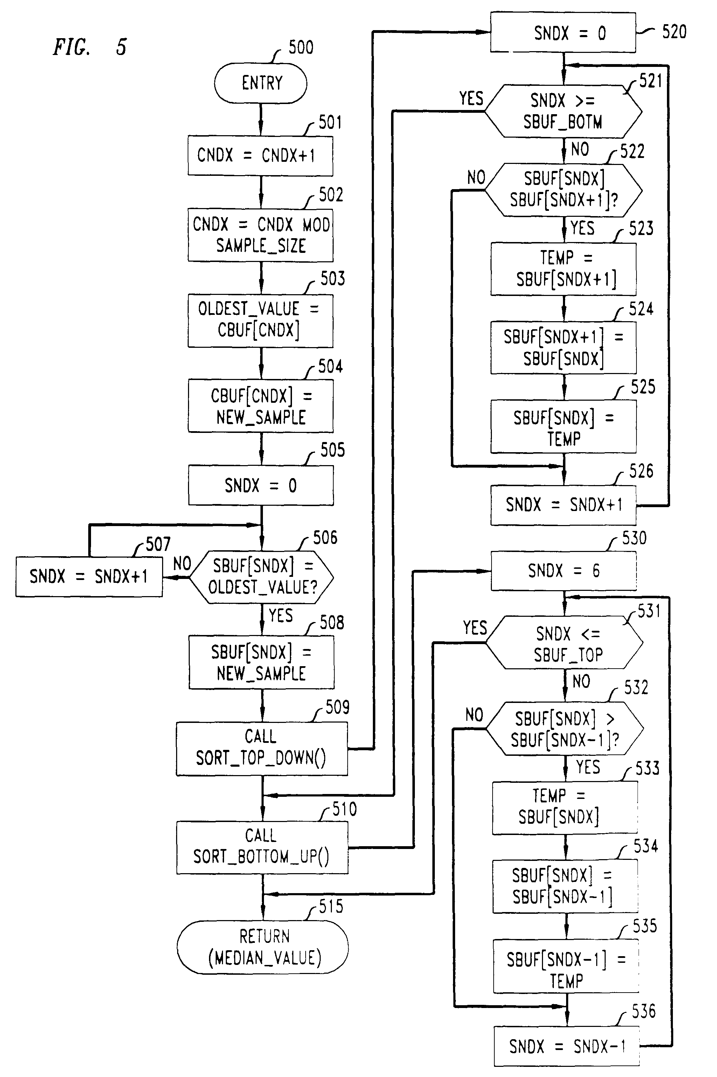

Aspects of the above-described illustrative software embodiment (a listing of which is provided in Appendix B) will now be further described with reference to the flowchart of FIG. 5.

*C Language Defines*

SAMPLE_SIZE   The number of data samples retained. Illustratively an odd integer value, such as 7 used in the example listing.

SBUF_TOP   Equivalent to the number 0. This permits more readable code, since the top of the sorted buffer array can be referred to by sbuf[SBUF_TOP].

SBUF_BOTM   Equivalent to SAMPLE_SIZE - 1. This permits more readable code since the bottom of the sorted buffer array can be referred to by sbuf[SBUF_BOTM].

MEDIAN_VALUE Equivalent to (SAMPLE_SIZE -1)/2. If SAMPLE_SIZE is 7, then MEDIAN_VALUE is 3. This is the position in the stored array that is output as the filtered value after each iteration.

*Declared Variables*

cbuf[cndx]   Circular buffer. A data array that holds the last [SAMPLE_SIZE] number of samples. When a new sample is entered, the oldest sample is over-written. The index to the array is named cndx. With each new sample, cndx is incremented. cndx ranges from 0 to SAMPLE_SIZE, then back to 0.

new_sample   The most recent data sample passed to the filter routine each time it is called.

oldest_value   The "most stale" data value that gets overwritten in the circular buffer by new_sample.

sbuf[sndx]   Sorted buffer. A data array that holds the same retained samples as the circular buffer, except this array is sorted in ascending order, negative to positive. The index to the array is sndx.

*Subroutines*

Sort_top_down()   A subroutine that sorts the sorted buffer sbuf[] from top to bottom. More positive values are moved down to their proper positions.

Sort_bottom_up()   A subroutine that sorts the sorted buffer sbuf[] from bottom to top. More negative values are moved up to their proper positions.

*Summary of steps Performed in the Flowchart of FIG. 5*

1. Point to the next location in the circular buffer. (Steps 501, 502):
    ++cndx;
    cndx%=SAMPLE_SIZE

2. Make copy of oldest value, then replace with new_sample (Steps 505-508)
    oldest_value = cbuf[cndx];
    cbu[cndx] = new_sample;

3. Find the location in the sorted buffer that holds oldest_value. Replace with new_sample. (Steps 505-508)

```
for(sndx=SBUF_TOP), sndx<=SBUF_BOT; sndx++ {

    If (sbuf[sndx] == oldest_value) {

        sbuf[sndx] = new_sample;

        break;

    }

}
```

4. Resort the sorted buffer:
    sort_top_down(); (Steps 509 and 520-526)
    sort_bottom_up(); (Steps 510 and 530-536)

5. Output the filtered value.
    Return sbuf[MEDIAN_VALUE]; (Step 515).

Other glitch filtering methods and associated systems for practicing such methods, all within the scope of the present invention, will occur to those skilled in the art. Thus, while particular sorting methods and functions are described, it will be understood that other sorting methods may be used to order a sequence of input samples in accordance with sample values for selection of one or more output values. While the particular values for system and method parameters, *e.g.,* N = 7, were used for illustration, no such value is fundamental to all embodiments of the present invention. In appropriate cases, a user may adjust the value for N to accommodate particular data or system characteristics or constraints.

While use of some illustrative embodiments of the present invention contemplate use of FPGAs, it will be clear to those skilled in the art that, in appropriate cases, parts or all of application specific integrated circuits (ASICs) may be designed to implement some or all of the elements of embodiments of the present invention. Likewise, no particular computer, programming language, memory configuration or peripheral (or peripheral configuration) is essential to the present invention.

While the above illustrative examples were presented, in part, in terms of processing of audio signals, the inventive teachings are not so limited. Thus, when adjustments familiar to those skilled in the art are made to component speeds, sampling rates and the like, processing of a wide variety of continuous corrupted signals may be accommodated.

While the preceding description has proceed on the basis of processing of the N most recent samples, with N being an odd integer, in appropriate cases N may be other than an odd integer. Thus, for example, if N is large, it may prove adequate to choose one of two or more sample values centrally located in a sorted list of sample values. Or, some easily derived function (*e.g.*, the numerical average) of a plurality of centrally located values may be used. Moreover, the selection may be adjustable depending on actual values of the stored samples.

While the updating of stored samples for each time interval was described above in terms of adding a single new sample and discarding the oldest single previous sample, in appropriate cases more than one sample may be added, and the same number of oldest samples discarded, during an appropriately adjusted time interval.

## Appendix A

**Main routine call to sort_filter**

```
include <stdio.h>

int sort_filter(int new_sample)

int j, median_value;

FILE *fptr, *foptr;


main (void)  {

        FILE   *fptr, *foptr;

        fptr   = fopen("a:\datafile.txt",  "r");

        foptr  = fopen("a:\sim_out.txt",  "w");


        while (  fscanf(fptr, "%d",  &j)  ! = EOF) {

                median_value = sort_filter(j);

                fprintf(foptr,  "%d\n",  median_value);

                }

        }
```

## Appendix B

```
#define        SAMPLE_SIZE  7 /* SAMPLE_SIZE is the number of samples stored*/

#define        SBUF_TOP        0 /*  Index of top of array.  sbuf[SBUF_TOP]. */

#define        SBUF_BOTM     (SAMPLE_SIZE-1)      /* Here, = 6. */

#define        MEDIAN_VALUE (SAMPLE_SIZE/2)      /* Here, = 3. (Integer math)*/


static int cbuf[SAMPLE_SIZE] ;       /* Declare circular and sorted buffers. */

static Int cbuf[SAMPLE_SIZE];

static unsigned char cndx; /* Declare indexes to circular and sorted buffers. */

Static unsigned char sndx;


int sort_filter (int new_sample);

        int oldest_value;


/* Copy oldest value and replace with new. */

        ++cndx;                        /* Increment circular buffer index */

        cndx%+SAMPLE_SIZE;      /* Set to zero when equal to SAMPLE_SIZE. */

        oldest_value = cbuf[cndx];    /* Retain oldest value in "oldest_value." */

        cbuf[cndx    = new_sample; /* Overwrite circ buffer with new value */

/* replace first occurrence of oldest value in sorted buffer with new sample. */


        for(sndx=SBUF_TOP; SNDX<=SBUF_BOTM; sndx++)  {

            if(sbuf[sndx] == oldest_value) {      /* Found ! */

                sbuf[sndx  = new_sample;    /* Overwrite old with new */
```

```
                break;                    /* Exit loop – done. */

            }

        }

/* Since sorted buffer is already sorted except for new sample, one sort top to bottom and

    another sort bottom to top is sufficient. */



        sort_top_down();

        sort_bottom_up();

        return sbuf[MEDIAN_VALUE];    /* Return value located in sbuf[3]. */



/*═══════════════════════════► SORT TOP DOWN
◄═══════════════════════*/

sort_top_down() {

        int temp;

        for(sndx=SBUF_TOP; SNDX<(SBUF_BOTM); sndx++) {/*Sort from top down*/

            if(sbuf[sndx] < sbuf[sndx+1]) {

                temp = sbuf[sndx+1];

        .       sbuf[sndx+1] = sbuf[sndx];

                sbuf[sndx] = temp;

            }

        }

        return(0);

    }

/*═══════════════════════════► SORT BOTTOM UP
◄═══════════════════════*/
```

```
sort_bottom_up() {

        int temp;

        for(sndx=SBUF_BOTM; sndx>SBUF_TOP; sndx--) {  /*Sort from bottom up*/

                if(sbuf[sndx] < sbuf[sndx-1]) {

                        temp = sbuf[sndx];

                        sbuf[sndx] = sbuf[sndx-1];

                        sbuf[sndx-1] = temp;

                        }

                }

        return(0);

                }
```

## Claims

1. A method for processing a sequence of input digital signals, each of said input digital signals having a numerical value, at least some of said values of said input digital signals being corrupted by glitches, the method comprising the steps of

   storing a set of N current input digital signals in a set of N ordered storage locations,

   sorting said set of N current input digital signals in accordance with their respective numerical values to form a sorted list of said N current signals, and

   selecting the central value from said sorted list as an output value.

2. The method of claim 1 wherein N is an odd integer.

3. The method of claim 1 further comprising the steps of

   deleting the oldest M input digital signals from said set,

   adding M new input digital signals to said set, thereby to generate an updated set of N current input digital signals, and

   repeating said steps of claim 1 to generate an output value.

4. The method of claim 3, wherein M = 1, said input digital signals occur periodically with period $t$ seconds, and said updating is accomplished repetitively for successive t-second time intervals.

5. The method of claim 1 wherein said sorting step is accomplished by performing a sequence of pair-wise comparisons of said stored input digital signals.

6. The method of claim 5 wherein said ordered storage locations are ordered in higher and lower relation and said pair-wise comparisons result in an exchange of contents of storage locations when signals have a predetermined relationship to each other.

7. The method of claim 6 wherein said predetermined relationship is the occurrence of a more positive value in the lower of a pair of storage locations being compared.

8. The method of claim 4 wherein for each interval said updating is performed by retaining the ordered relationship of the remaining stored data signals from the previous interval, and sorting said remaining data signals with said added input data signals in a single-pass sort.

9. A system for processing a sequence of input digital signals, each of said input digital signals having a numerical value, at least some of said values of said input digital signals being corrupted by glitches, the system comprising

means for storing a set of N current input digital signals in a set of N ordered storage locations,

means for sorting said set ofN current input digital signals in accordance with their respective numerical values to form a sorted list of said N current signals, and

means for selecting the central value from said sorted list as an output value.

10. The system of claim 9 wherein N is an odd integer.

11. The system of claim 10 wherein said input digital signals occur periodically with period $t$ seconds, said system further comprising

means for deleting the oldest M input digital signals from said set,

means for adding M new input digital signals to said set of stored digital signals, thereby to generate an updated set ofN current input digital signals for processing in a subsequent $t$-second time interval.

12. The system of claim 11, wherein M = 1.

13. The system of claim 9 wherein said means for sorting comprises means for performing a sequence of pair-wise comparisons of said stored input digital signals.

14. The system of claim 13 wherein said ordered storage locations are ordered in higher and lower relation and means for performing said pair-wise comparisons comprises means for performing an exchange of contents of storage locations when signals in said storage locations have a predetermined relationship to each other.

15. The system of claim 14 wherein said means for performing said exchange of contents comprises means for performing said exchange of contents when the lower of a pair of storage locations being compared is found to store a value that is more positive than the value stored in the higher of said pair of storage locations being compared.

FIG. 1

FIG. 2

*FIG. 3*

300 → SAMPLER 301 → QUANITIZER 302 → N-SAMPLE DELAY 303 → SORTER 304 → MID-POINT SELECTOR 305 → OUT

*FIG. 4*

SAMPLE 1 405 → MUX A 410 → COMPARE LOGIC 420 → COMPARE LOGIC 425 → 430 OUTPUT
SAMPLE 2 → MUX B
SAMPLE 3 → MUX C
SAMPLE 4 → MUX D
SAMPLE 5 → MUX E
SAMPLE 6 → MUX F
SAMPLE 7 → MUX G

440
435

EP 0 984 556 A2

**FIG. 5**

ENTRY — 500

CNDX = CNDX+1 — 501

CNDX = CNDX MOD SAMPLE_SIZE — 502

OLDEST_VALUE = CBUF[CNDX] — 503

CBUF[CNDX] = NEW_SAMPLE — 504

SNDX = 0 — 505

SNDX = SNDX+1 — 507

SBUF[SNDX] = OLDEST_VALUE? — 506  NO → 507 ; YES

SBUF[SNDX] = NEW_SAMPLE — 508

CALL SORT_TOP_DOWN() — 509

CALL SORT_BOTTOM_UP() — 510

RETURN (MEDIAN_VALUE) — 515

SNDX = 0 — 520

SNDX >= SBUF_BOTM — 521  YES ; NO

SBUF[SNDX] SBUF[SNDX+1]? — 522  NO ; YES

TEMP = SBUF[SNDX+1] — 523

SBUF[SNDX+1] = SBUF[SNDX] — 524

SBUF[SNDX] = TEMP — 525

SNDX = SNDX+1 — 526

SNDX = 6 — 530

SNDX <= SBUF_TOP — 531  YES ; NO

SBUF[SNDX] > SBUF[SNDX-1]? — 532  NO ; YES

TEMP = SBUF[SNDX] — 533

SBUF[SNDX] = SBUF[SNDX-1] — 534

SBUF[SNDX-1] = TEMP — 535

SNDX = SNDX-1 — 536

14